# EUROPEAN PATENT APPLICATION

(11) **EP 0 689 094 A1**
(43) Date of publication of application: **27.12.1995**
(21) Application number: 95201407.4
(22) Date of filing: 30.05.1995
(51) Int. Cl.: G03F 7/00, G02B 6/12, G03F 7/095

(54) **Bleaching mask**

(30) Priority: 23.06.1994 EP 94201811
(71) Applicant: Akzo Nobel N.V., NL-6824 BM Arnhem (NL)
(72) Inventor: Hoekstra, Tsjerk Hans, NL-7552 LH Hengelo (NL)
(74) Representative: Schalkwijk, Pieter Cornelis

(57) **Abstract**

The invention concerns a method of making a polymeric optical waveguide component employing a waveguiding material susceptible to a change of refractive index when subjected to irradiation of the proper wavelength, i.e. a bleachable polymer, in which the mask used for defining the areas to be bleached is in the form of a developed photoresist that is not substantially transparent to the irradiation wavelength. Thus, a simplified process is provided by which a pattern of laterally defined waveguide channels can be made in a polymeric optical waveguide. The photoresist substantially absorbs the wavelength used for bleaching. This may be accomplished by employing dye molecules which absorb energy of the proper wavelength.

## Description

The invention concerns optical waveguides. Such waveguides generally are built up such that light can propagate within the confinement of a waveguiding material surrounded by a material having a lower refractive index than the waveguiding material

The invention is directed to a method of making a polymeric optical waveguide component employing a waveguiding material susceptible to a change of refractive index when subjected to irradiation of the proper wavelength (i.e., a bleachable polymer), comprising the steps of providing said waveguiding material with a mask selectively covering portions thereof and then irradiating it through said mask so as to change the refractive index of the portions of the waveguiding material not covered.

More particularly, the invention concerns layered waveguide components comprising a layered polymeric optical waveguide structure which comprises a light guiding layer of a bleachable polymer sandwiched between two deflection layers of lower refractive index than the light guiding layer. Thus, the wave confinement in vertical direction (i.e., perpendicular to the layers) is determined by the layered structure. Waveguide channels are laterally defined by selectively changing the refractive index of the bleachable polymer in the light guiding layer.

A method as described above is known from US 5,142,605 (and corresponding EP 358 476), which disclosure is hereby incorporated by reference into this description for all purposes. The change of refractive index usually amounts to a decrease, so that waveguide channels can be created by irradiating the material surrounding the desired wave confinement. It is described that the selective exposure of the polymeric material to the irradiation may occur through a mask having parts which are transparent and parts which are opaque to the applied irradiation.

In practice, the only viable mask known is a metal mask. While the metal, usually gold or aluminium, very effectively prohibits the bleaching irradiation from reaching the portions of the waveguiding polymer that should not be bleached, the use of a metal mask has various drawbacks.

One such drawback is that the process is extensive and complicated. It generally involves the following steps:
(a) making a layered waveguide;
(b) applying a metal film onto the waveguide;
(c) providing the metal film with a photoresist layer;
(d) selectively exposing the photoresist through a mask defining the desired pattern of lateral wave confinement;
(e) developing the photoresist so as to selectively uncover the metal;
(f) etching away the uncovered metal portions so as to make openings;
(g) stripping off the photoresist;
(h) irradiating the waveguide through said openings with irradiation that causes the refractive index of the waveguiding polymer to change;
(i) etching away the metal.

If an electro-optically active waveguide is made, it is possible to refrain from removing the metal mask, as it can be used as an electrode. However, in that case the electrodes will have the same shape as the bleaching mask, which is a serious design limitation. For passive waveguide components and thermo-optic waveguide components, the metal layer is always redundant and has to be removed.

Such a process, which involves the application and the removal of an expensive noble metal, is cumbersome and uneconomical. Besides, it requires the use of expensive apparatus. Also, after removal of the metal mask usually undesired metal residues remain.

Several further drawbacks apply. Etching the metal by means of a photoresist mask will generally lead to "underetching", i.e., the resulting metal strip, and thus the eventual wave confinement, will have a smaller width than the resist strip above it. Besides, etching of the metal may lead to walls having an undesirable roughness. Hence, it is desired to provide a process by which the wave confinements can be defined more precisely. Further, since the etchants used for the metal may be harmful to the waveguide polymer, it is advantageous if their use can be avoided.

It is an object of the invention to provide a bleaching process in which these drawbacks are not incurred. To this end, the invention consists therein that, in a method as described in the opening paragraph, the mask is a developed photoresist that is not substantially transparent to the irradiation wavelength.

The resulting process comprises the following steps:
(a) making a layered waveguide;
(b) applying a photoresist layer onto the waveguide;
(c) exposing the photoresist through a mask defining the desired pattern of lateral wave confinement;
(d) developing the photoresist so as to make openings, thus selectively uncovering the waveguide;
(e) irradiating the waveguide through said openings with radiation that causes the refractive index of the guiding layer polymer to change;
(f) stripping the photoresist.

This surprisingly simple process is made feasible by virtue of the use of a photoresist that has a low transmission for the irradiation wavelength. A transmission of about 50% is sufficient to achieve a refractive index contrast between bleached and unbleached polymer of about 0.003, on the basis of which favourable waveguide channels result. As a guideline for determining the suitability of a photoresist, it can be stated in general that it should have an opacity of at least 50% (i.e., a transmission of at the most 50%). However, depending on the wavelength as well as on the bleaching susceptibility of the guiding layer polymer, it may turn out that either a substantially higher transmission (e.g.75%) will still give an acceptable refractive index contrast, or that the transmission should be much lower (e.g. 25%) in order for the photoresist to be not substantially transparent to the irradaiation wavelength. Generally, suitable photoresists are those that will absorb the energy of the bleaching wavelength. Preferably, this is accomplished by employing a photoresist that comprises dye molecules having absorption bands within the proper wavelength. Photoresists containing metal or semiconductor particals, e.g. silicium-containing resists, may also be used.

The wavelength to be used depends on the polymer utilized in the guiding layer. Suitable polymers have been described, int.al., in EP 358 476. The invention is not limited to any particular type of polymer, as long as it is susceptible to a change of refractive index when subjected to irradiation of a certain wavelength or within a certain wavelength range.

The bleaching irradiation will usually be UV or visible light, blue light being preferred in most instances. Suitable potoresists in general are known as "dyed resists." They include those marketed by Hoechst AG under the names of AZ 6618-2DG, AZ 6218B-3DG, which both absorb at 436 nm, and AZ 7510-2DG, which absorbs at 365 nm. Other dyed resists are those marketed by Shipley under the name microposit (S1813-J2, S1818-J2, S1400-27 D1, S1400-31 D1). If the bleaching irradiation has a wavelength in the range of from 200-300 nm, many conventional photoresists can be employed as a bleaching mask. Templates which are partially transparent and partially opaque to UV irradiation have been described in DD 114717, for use in making printed circuit boards.

It is required that the photoresist can be developed by means of a developer that does not damage the polymer onto which the photoresist is applied (usually the top deflection layer). The above-mentioned photoresists can be developed using metal ion-free or metal ion-based developers. Suitable developers are usually recommended by the photoresist supplier.

Basically, the method of the invention can be used to make all types of polymeric optical waveguide components. E.g., electro-optic components, in which case the bleachable polymer can be made electro-optically active (i.e. an NLO polymer), thermo-optic components, and passive components. Such components are known in general to the man skilled in the art and for the purpose of the present invention do not require further elucidation here.

The process of the invention is further illustrated in the accompanying drawings, which are not to be considered to be limiting the invention in any way.

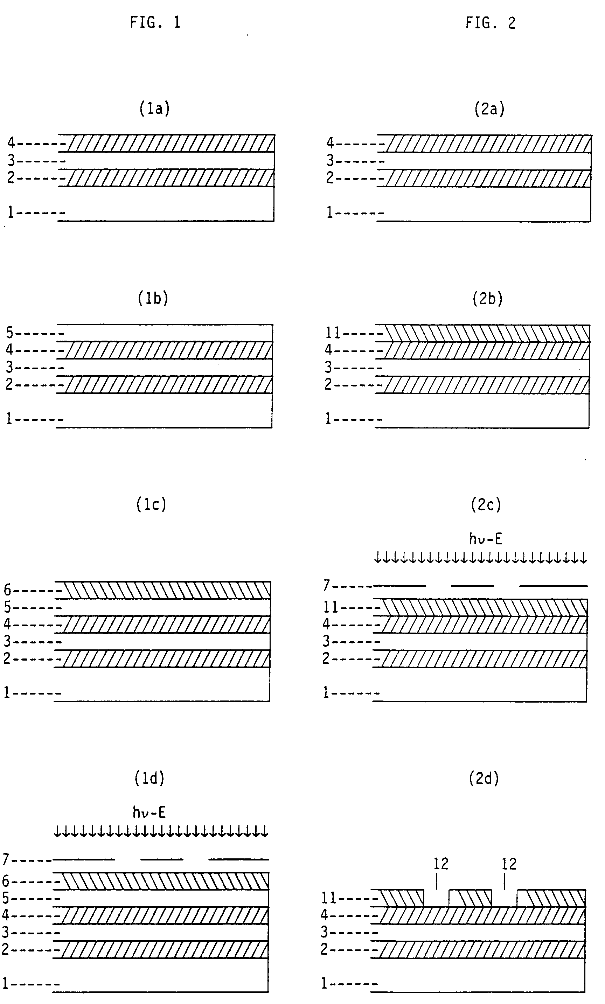

Figure 1 shows the conventional, prior art process, Figure 2 the process of the present invention. In both Figures, the subsequent process steps have been indicated with the letters also used above. I.e., the prior art process involves the steps (1a) through (1i), while the process of the invention involves the steps (2a) through (2f). In both Figures, the structure displayed with regard to each step is a crosssection of the layers, perpendicular to the light guiding direction.

### Description of Figure 1:

In Fig. 1a, a layered waveguide is shown which comprises a substrate (1), a lower deflection layer (2), a wave guiding layer (3), and a top deflection layer (4). It is also possible to omit the top deflection layer at mhis stage and apply it after the wave confinement has been formed.

In Fig. 1b, the same structure is shown, with a metal layer (5) having been applied onto the top deflection layer (4).

In Fig. 1c, it is shown that a photoresist layer (6) is applied onto the metal layer.

In Fig. 1d, it is shown how the photoresist layer (6) is exposed through a mask (7), with hν-E indicating the exposure irradiation employed (usually during about 3-5 seconds) to activate the photoresist layer.

In Fig. 1e, it is shown how the exposure and the development of the photoresist layer (6) through the mask result in the metal being selectively uncovered.

In Fig. 1f, it is shown that the uncovered metal portions have been etched away, so as to make openings (8) in the metal layer (5).

In Fig. 1g, it is shown that the photoresist has been stripped off. The waveguide remains to be covered by a mask comprising metal (5) and openings (8).

In Fig. 1h, the irradiation of the waveguide through the openings is depicted, with hν-B indicating the bleaching irradiation employed (usually during about 4-12 hours) to induce the desired refractive index change in the guiding layer polymer.

In Fig. 1i, it is shown that the metal has been etched away and the guiding layer (3) appropriately bleached so as to include wave confinements (9) surrounded by bleached material (10).

### Description of Figure 2:

In Fig. 2a, a layered waveguide is shown which comprises a substrate (1), a lower deflection layer (2), a wave guiding layer (3), and a top deflection layer (4). Again, it is also possible to omit the top deflection layer at this stage and apply it after the wave confinement has been formed.

In Fig. 2b, the same structure is shown, with a photoresist layer (11) having been applied onto the top deflection layer (4).

In Fig. 2c, it is shown how the photoresist layer (11) is exposed through a mask (7), with hν-E indicating the exposure irradiation employed (usually during about 3-5 seconds) to activate the photoresist.

In Fig. 2d, it is shown how the exposure and the development of the photoresist layer (11) through the mask result in openings (12).

In Fig. 2e, the irradiation of the waveguide through the openings (12) in the photoresist layer (11) is depicted, with hν-B indicating the bleaching irradiation employed (usually during about 4-12 hours) to induce the desired refractive index change in the guiding layer polymer.

In Fig. 2f, it is shown that the photoresist has been stripped off and the guiding layer (3) appropriately bleached so as to include wave confinements (9), surrounded by bleached material (10).

## Claims

1. A method of making a polymeric optical waveguide component employing a waveguiding material susceptible to a change of refractive index when subjected to irradiation of the proper wavelength, comprising the steps of providing said waveguiding material with a mask selectively covering portions of said waveguiding material, and irradiating the waveguiding material through said mask so as to change the refractive index of the portions of the waveguiding material not covered, characterized in that the mask is a developed photoresist that is not substantially transparent to the irradiation wavelength.

2. A method of making a pattern of laterally defined waveguide channels in a polymeric optical waveguide comprising the following steps:
(a) providing a waveguide having a layered structure comprising a polymeric guiding layer (3) sandwiched between two deflection layers of lower refractive index than the guiding layer (2,4);
(b) applying a photoresist layer (11) onto said layered waveguide;
(c) exposing the photoresist through a mask (7) defining the desired pattern;
(d) developing the photoresist so as to generate openings (12) defining a pattern of covered portions and uncovered portions of the layered waveguide;
(e) subjecting the pattern-wise covered waveguide to irradiation with a wavelength that causes the refractive index of the guiding layer polymer to change;
the developed photoresist being not substantially transparent to the irradiation wavelength.

3. A method according to claim 1 or 2, characterized in that the developed photoresist substantially absorbs the wavelength used.

4. A method according to claim 3, characterized in that the photoresist comprises dye molecules which absorb energy of the proper wavelength.

5. The use of a photoresist which is substantially opaque to light of a certain wavelength or wavelength range for defining a pattern of one or more waveguide channels in a planar optical waveguide by irradiating said waveguide with irradiation of said wavelength or within said wavelength range.
